(19) Europäisches Patentamt
European Patent Office
Office européen des brevets

(11) EP 0 276 959 B1

(12) **EUROPEAN PATENT SPECIFICATION**

(45) Date of publication and mention
of the grant of the patent:
**22.09.1999 Bulletin 1999/38**

(51) Int Cl.⁶: **H01L 21/20**, H01L 21/31

(21) Application number: **88300572.0**

(22) Date of filing: **25.01.1988**

(54) **Process for producing crystal article**

Verfahren zur Herstellung kristalliner Artikel

Procédé pour produire un article cristallin

(84) Designated Contracting States:
**DE FR GB IT NL**

(30) Priority: **26.01.1987 JP 1410287**

(43) Date of publication of application:
**03.08.1988 Bulletin 1988/31**

(73) Proprietor: **CANON KABUSHIKI KAISHA
Tokyo (JP)**

(72) Inventor: **Mizutani, Hidemasa
Sagamihara-shi Kanagawa-ken (JP)**

(74) Representative:
**Beresford, Keith Denis Lewis et al
BERESFORD & Co.
High Holborn
2-5 Warwick Court
London WC1R 5DJ (GB)**

(56) References cited:
EP-A- 0 241 204        EP-A- 0 244 081
FR-A- 2 216 077        US-A- 4 239 788

- PATENT ABSTRACTS OF JAPAN, vol. 8, no. 172
  (C-237)[1609], 9th August 1984; & JP-A-59 69 495
  (NIPPON DENSHIN DENWA KOSHA) 19-04-1984
- IDEM
- BRITISH JOURNAL OF APPLIED PHYSICS, vol.
  18, no. 10, October 1967, pages 1357-1382, GB;
  J.D. FILBY et al.: "Single-crystal films of silicon
  on insulators"
- JOURNAL OF THE ELECTROCHEMICAL
  SOCIETY, vol. 127, no. 1, January 1980, pages
  194-202; W.A.P. CLAASSEN et al.: "The
  nucleation of CVD silicon on SiO2 and Si3N4
  substrates"
- Sensors and Activators 9(1986) July, No.4,
  Lausanne, Switzerland, pp333-343
- Appl. Phys. Lett., vol.55, No.7, 14 August, 1989,
  pp.636-638
- Solid State Technology, vol. 27, No. 9, 1984,
  pp.239-243
- App. Phys. Lett, vol 54, No. 26, 26 June 1989,
  pp.2648-2650
- Mat. Res. Soc. Symp. Proc. vol. 106, 1988,
  pp.21-26
- Crystal Growth, Akiya Okawa, 5th ed, 20 July
  1987

## Description

This invention concerns a method for producing a plurality of single crystal silicon islets in the surface of a recessed $SiO_2$ substrate. It may be adopted in the production of SOI devices.

In the prior art, single crystalline thin film to be used for semiconductor electronic devices, photoelectric devices, etc. has been formed by epitaxial growth on a single crystalline substrate. However, for epitaxial growth of single crystalline thin film on a single crystalline substrate, it is necessary to take account of matching in lattice constants and coefficients of thermal expansion between the single crystalline material of the substrate and the epitaxial growth layer.

Research and development of large area semiconductor devices such as solar batteries, in which elements are arranged in an array on an inexpensive glass, or switching transistors, of active liquid crystal displays, etc., are becoming more active year by year.

What is common in such research and development, is a need for a method to form semiconductor film on amorphous insulating material, in which film electronic elements such as transistors, etc., can be produced. It has been particularly desired to have a technique to form single crystalline semiconductor material of high quality on an amorphous insulating material.

However, generally speaking, when a thin film is formed on an amorphous insulating substrate such as $SiO_2$. due to a lack of long range order of the substrate material, the crystal structure of the deposited film becomes amorphous or polycrystalline, whereby it has not been possible to form a single crystalline semiconductor of high quality. Here, amorphous film refers to one with a state in which short range order to a minimum extent on the order of a few atoms may be maintained, but there is no long range order; while the polycrystalline films referred to are those in which single crystal grains, having no specific crystal direction are separated by grain boundaries.

As a solution to the problems in the prior art, as mentioned above, European Patent Application EP-A-244081 (which is mentioned here with reference to Article 54(3)EPC) proposes a method for forming crystal grains by growing each single crystal grain from a single nucleus as a growing centre, each on a nucleation surface ($S_{NDL}$) provided on a substrate surface, which nucleation surface is constituted of a material sufficiently larger in nucleation density (ND) than the material constituting the substrate surface and has an area sufficiently small to the extent that only a single crystal can be grown, and by use of this method, it is shown possible to form single crystal grains on an insulating amorphous substrate at predetermined positions.

In the invention shown in the above European Patent Application, when a single crystalline layer is formed on a substrate, facets inherent in single crystal are generated, and therefore flattening is required for formation of a circuit element on the single crystalline layer. Particularly, when recesses are formed in the substrate and a single crystal is formed in each recess, it is necessary to remove the surplus single crystal material protruding from each recess with good precision in conformity with the upper surface of the substrate in order to improve the precision of fine working in subsequent device production.

The above mentioned European Patent Application discloses both growth of polycrystalline film of controlled grain size and defined grain position and growth of single crystal islets embedded in a recessed substrate. Comparing these, it suggests that, in the latter case, the flattening and removal of grain portions is unnecessary.

European Patent Application EP-A-0241204 (which too is mentioned with reference to Article 54(3) EPC) concerns methods based on those of EP-A-0244081 discussed above. A particular feature of these is the selection of gaseous species, one as source for the deposited material, the other, a gaseous halogenic oxidising agent having the property of oxidative action on the source species.

An object of the present invention is to provide a method for producing a plurality of silicon single crystal islets in the surface of a recessed $SiO_2$ substrate on which surface portions of single crystal, formed in the recessed substrate are removed efficiently and with high precision.

Accordingly, this method comprises:

establishing a deposition surface area in each one of a plurality of the recesses of the substrate, each said deposition surface area having a property of nucleating silicon at a higher nucleation density than that of the bottom surface of each recess, and each being limited in area to a size which is suitable for forming thereon a single nucleus of silicon from which a single crystal of silicon is to be grown;

depositing silicon and forming thereby, selectively on substantially each of the deposition surface areas (2), a single nucleus of silicon from which a single crystal of silicon is to be grown;

growing single crystal silicon from each single nucleus and filling thereby each respective recess; and

subjecting the substrate to rotary working whilst it is pressed against a polishing pad provided on a rotary disc, whilst feeding from a polishing liquid source a polishing liquid of ethylenediamine, pyrocatechol and water which reacts with silicon to form $Si(OH)_6^{2-}$ which is removed by the polishing pad so that surplus single crystal silicon is removed until polishing is automatically stopped by the $SiO_2$ surface which acts as a stopper.

The deposition surface areas may be formed, for example, of $Si_zN_4$ deposited by reduced pressure chemical deposition, and patterned by plasma etching using a photoresist mask.

In the accompanying drawings:

Figs. 1(A)-1(C) are schematic illustrations for explaining the method of the present invention;

Fig. 2 is a schematic perspective view of a polishing device for illustration of selective polishing used in the method of the present invention;

Fig. 3 is a schematic sectional view of MOS type transistors defined in islets produced by the method of the present invention;

Fig. 4 is a graph showing the manner in which the free energy G of a nucleus varies;

Figs. 5(A) and 5(B) are diagrams for illustration of selective deposition;

Fig. 6 is a graph showing changes in nucleation density (ND) with lapse of time on a deposition surface of $SiO_2$ and on a deposition surface of silicon nitride;

Figs. 7(A)-7(D) are diagrams for illustration of the principle of the production of single crystal;

Figs. 8(A) and 8(B) are perspective views of Figs. 7(A) and 7(D);

Fig. 9 is a graph showing one example of the relationship between flow rate ratio of $NH_3$ to $SiH_4$ and composition ratio of Si/N of silicon nitride film;

Fig. 10 is a graph showing the relationship between Si/N composition ratio and nucleation density (ND); and

Fig. 11 is a graph showing the relationship between Si ion implantation rate and nucleation density (ND).

Referring now to the accompanying drawings, an embodiment of the present invention will be described in detail.

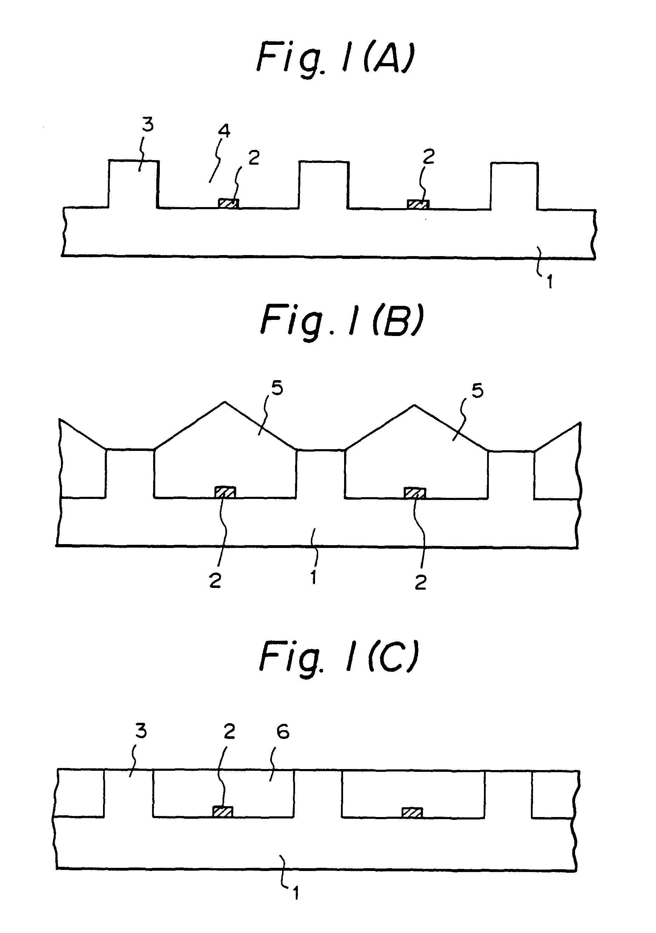

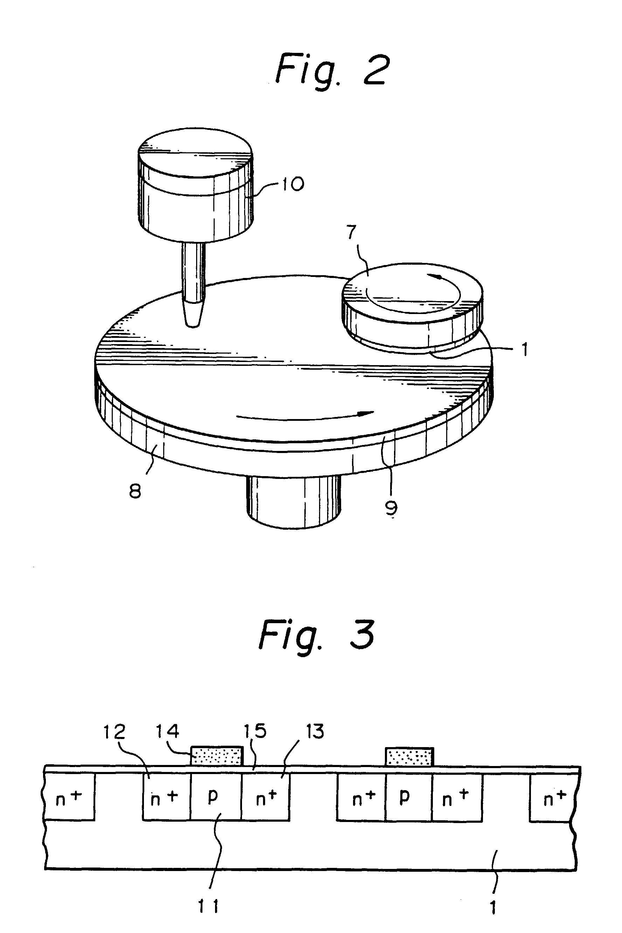

Figs. 1(A)-1(C) are schematic preparation step diagrams showing an embodiment of the method of the present invention, and Fig. 2 is a schematic perspective view for illustration of the selective polishing method to be used in the method of the present invention.

First, as shown in Fig. 1(A), recesses 4 are formed with side wall portions 3 remaining on a substrate 1 of $SiO_2$ (silicon oxide) by photoetching. Then, on the surface of the substrate is deposited, for example, a deposition film for formation of each single nucleus, such as a film of $Si_3N_4$ (silicon nitride) with a thickness of about 30 nm (300 Å), by reduced pressure CVD. By plasma etching after resist patterning, the $SiO_2$ surface is exposed leaving respective $Si_3N_4$ film portions 2 each with a small area at the central portions of the recesses 4 while other portions are removed.

Next, as shown in Fig. 1(B), with each $Si_3N_4$ film portion 2 as a centre, respective single nuclei of Si are grown, and single crystals of Si are grown from each of the single nuclei. At this time, particular facets exist in the single crystals 5 and crystal growth occurs along these facets, and therefore when grown until completely embedding the recesses 4, parts will protrude above the upper surface of the substrate 1.

Finally, as shown in Fig. 1(C), the single crystal material protruding above the upper surface of the substrate is removed by selective polishing (see below) to form flat single crystal islets 6.

The selective polishing method adopted herein is reported in Research Report SSD86-63 of Society of Electrical Communication, and is a polishing method comprising a combination of mechanical polishing and chemical polishing, which has improved working speed to great extent and enabled high precision polishing. In the following, this selective polishing method is to be explained. As shown in Fig. 2, the substrate 1 having a single crystal embedded in each recess is fixed with wax on a supporting plate 7 and pressed against a polishing pad 9 made of a polyester provided on a rotatory disc 8, and subjected to rotatory working using ethylenediamine pyrocatechol fed from a polishing liquid feeding source 10. At this time, Si reacts with amine and water to form $Si(OH)_6^{-2}$, which is removed by the polishing pad 9, whereby polishing of Si will proceed. As the polishing proceeds until reaching the upper surface of the side wall portion 3 of $SiO_2$, polishing will be stopped automatically, the $SiO_2$ acting as a stopper. As a result, as shown in Fig. 1(C), highly precise working is effected so that the surface of the single crystal region 6 and the upper surface of the side wall portion of $SiO_2$ may be on substantially the same plane.

Since single crystal protruding from the upper surface of the substrate can be removed by simple working, crystal islets can be formed with flat surfaces, fine working of photolithography, etc. when forming circuit devices can be effected with high precision, whereby integration can be achieved with ease.

Fig. 3 is a schematic sectional view of MOS type transistors defined in islets produced by the method of the present invention.

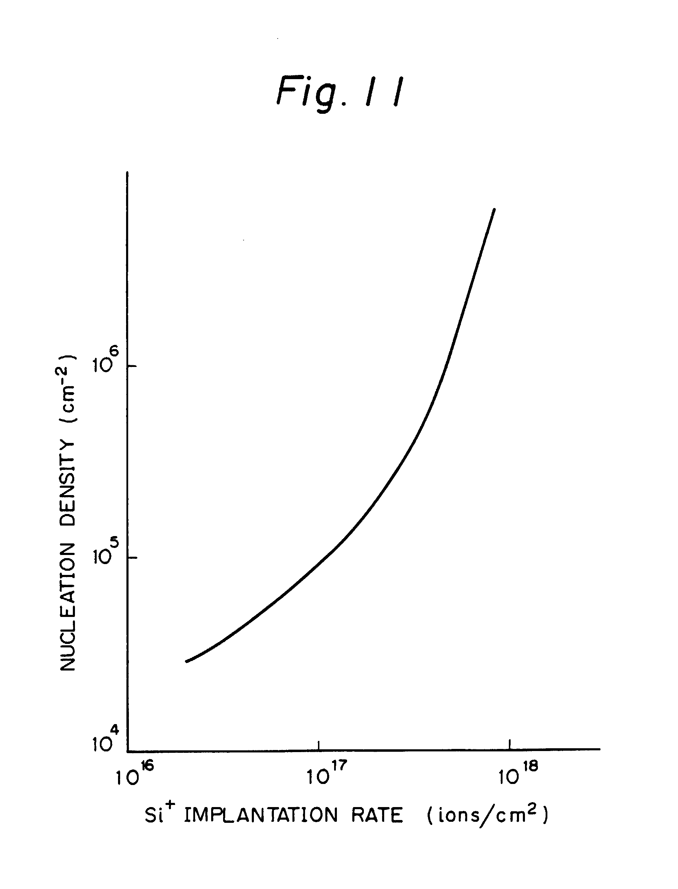

In Fig. 3, 11 is a P-type semiconductor region, which can be formed by doping with a P-type impurity during formation of single crystal in the production step shown in Fig. 1. 12 and 13 are N-type semiconductor regions, forming source and drain, respectively. 15 is a gate oxide film formed on the P-type semiconductor region 11 and N-type semiconductor regions 12 and 13, and 14 is a gate electrode formed on the gate oxide film 15.

Since the MOS type transistors as above are embedded in the insulating $SiO_2$ layer and are spaced by side wall portions thereof, it is not necessary to introduce further processing to separate the respective transistors. The respective transistors are completely separated by insulating material, and therefore this has the advantage that the transistors are free from latch-up and α-ray disorder.

The production steps of the MOS type transistors are not described here, because they can be formed according to conventional semiconductor processing.

Next, the single crystal growth method for growing single crystal silicon in each recess 4 in the substrate 1 is to be described in detail. As such single crystal growth method, one of the methods as disclosed in the above European Patent Application can be employed. First, for better understanding of such single crystal growth, general thin film forming of semiconductor is to be explained.

When the deposition surface is of a material different in kind from the flying atoms, particularly an amorphous material, the flying atoms will be freely diffused on the substrate or reevaporated (eliminated). And, as the result of collision between the atoms, a nucleus is formed, and when the nucleus reaches the size rc (=-2$\sigma_0$/gv) at which its free energy G becomes maximum (critical nucleus), G is reduced and the nucleus continues to grow three-dimensionally and becomes shaped as an island. The nucleus with a size exceeding rc is called "stable nucleus" and in the basic description of the present invention hereinbelow, "nucleus" unless otherwise specifically noted indicates a "stable nucleus".

Also, of the "stable nucleus", one with small r is called "initial nucleus". The free energy G formed by formation of the nucleus is represented by:

$$G=4\pi f(\theta)(\sigma_0 r^2 + 1/3 \, gv \, r^3)$$

$$f(\theta)=1/4(2 - 3\cos\theta + \cos^2\theta)$$

where

r: radius of curvature of nucleus
$\theta$: contact angle of nucleus
gv: free energy per unit deposition
$\sigma_0$: surface energy between nucleus and vacuum.

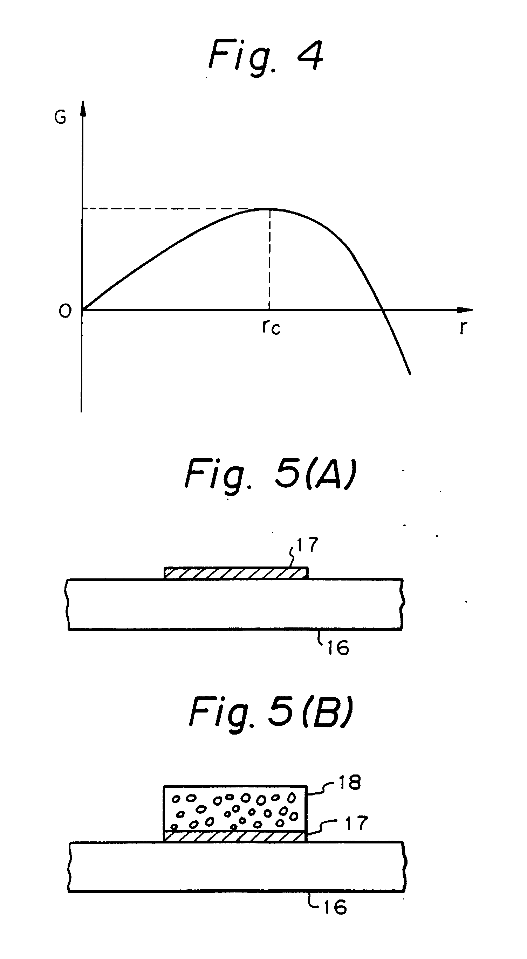

The manner in which G varies is shown in Fig. 4. In Fig. 4, the radius of curvature of the stable nucleus when G is at the maximum value is rc.

In the deposition process as described above, the density of the nucleus formed per unit area of the substrate surface, the size of the nucleus and the nucleation speed are determined depending on the state of the system of deposition, and particularly the interaction between the flying atoms and the substrate surface substance is an important factor. Also, a specific crystal direction grows in parallel to the substrate depending on the anisotropy relative to the crystal face of the interfacial energy at the interface between the deposited substance and the substrate, and when the substrate is amorphous, the crystal directions within the substrate plane are not constant.

Next, the selective deposition method for forming selectively a deposited film on a deposition surface is to be described. The selective deposition method is a method in which a thin film is selectively formed on a substrate by utilising the difference between the materials in the factors influencing nucleation in the thin film forming process such as surface energy, attachment coefficient, elimination coefficient, surface diffusion speed, etc.

Figs. 5(A) and 5(B) illustrate schematically the selective deposition method. First, as shown in Fig. 5(A), on the substrate 16, a thin film 17 of a material different in the above factors from the substrate 16 is formed at a desired position. And, when deposition of a thin film comprising an appropriate material is performed according to appropriate deposition conditions, it becomes possible to cause a phenomenon to occur such that the thin film 18 will grow only on the thin film 17 without growth on the substrate 16. By utilising this phenomenon, a thin film 18 formed self-matchingly can be grown, whereby the lithography step using resist, as practised in the prior art, can be omitted.

As the materials which can be deposited by such selective formation method, there is $SiO_2$ as the substrate 16, silicon nitride as the thin film 17, and Si, as the thin film 18 to be deposited.

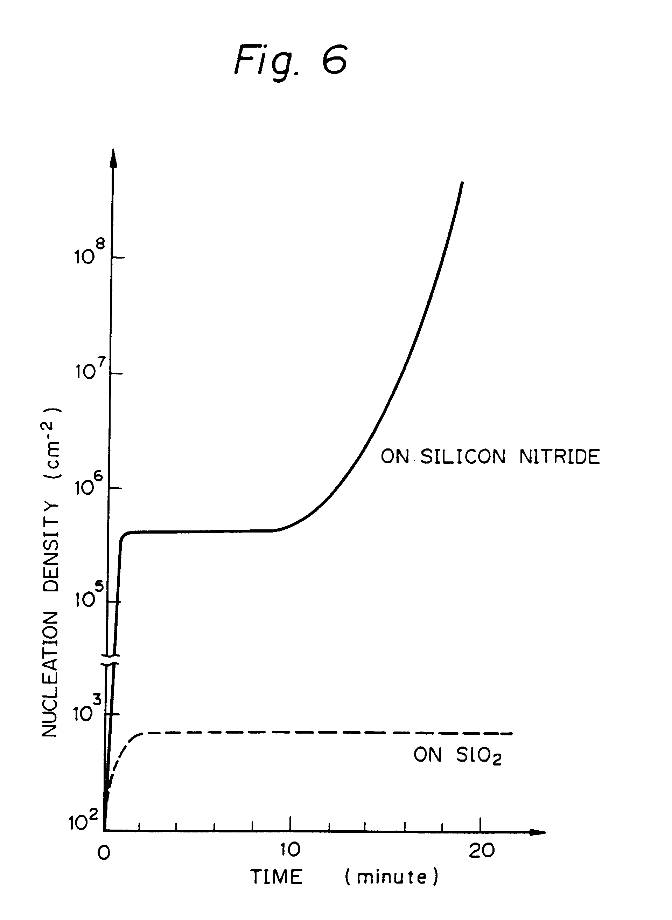

Fig. 6 is a graph showing changes in nucleation density (ND) with lapse of time on a deposition surface of $SiO_2$ and a deposition surface of silicon nitride.

As shown in Fig. 6, soon after initiation of deposition, the nucleation density (ND) on $SiO_2$ is saturated at less than $10^3 cm^{-2}$, and its value is substantially unchanged even after 20 minutes.

In contrast, on silicon nitride ($Si_3N_4$), the density is once saturated at $4 \times 10^5 \, cm^{-2}$, and is not changed for 10 minutes thereafter, but will be sequentially abruptly increased. In this measurement example, there is shown the case in which $SiCl_4$ gas is diluted with $H_2$ gas, and silicon is deposited by CVD under the conditions of a pressure of $2.33 \times 10^4$ Pa (175 Torr), and a temperature of 1000°C. Otherwise, the same effect can be obtained by using $SiH_4$, $SiH_2Cl_2$, $SiHCl_3$, $SiF_4$, etc. as the reactive gas and controlling pressure, temperature, etc. Alternatively, vacuum vapour deposition may be performed.

In this case, although nucleation on $SiO_2$ poses substantially no problem, nucleation on $SiO_2$ can be inhibited further by addition of HCl gas to the reactive gas, whereby deposition of Si on $SiO_2$ can be made zero.

Such phenomenon owes greatly to the difference in adsorption coefficient, elimination coefficient, surface diffusion coefficient, etc. relative to Si between the material surfaces of $SiO_2$ and silicon nitride, but it maybe also considered as a cause for selective deposition that $SiO_2$ itself is etched through the reaction of $SiO_2$ with Si atom itself to form silicon monoxide with high vapour pressure, while no such etching phenomenon occurs on silicon nitride (T. Yonehara, S. Yoshioka, S. Miyazawa, Journal of Applied Physics 53, 6839, 1982).

Thus, by selecting $SiO_2$ and silicon nitride as surface materials and selecting silicon as the material to be deposited, a sufficiently great nucleation density difference ($\Delta$ND) as shown in Fig. 6 can be obtained.

Of course, the present invention is not limited to these materials, but the nucleation density difference ($\Delta$ND) is sufficient if it is $10^3$-fold or more in terms of density as shown in the same graph, and sufficient selective formation of a deposited film can be performed with the materials as exemplified below.

As another method for obtaining sufficient nucleation density difference ($\Delta$ND), a region containing an excess of Si, N, etc. may be formed by ion implantation of Si, N, etc. locally in the $SiO_2$ surface.

The present invention utilises the selective deposition method based on such nucleation density difference ($\Delta$ND), and a deposition surface comprising a material of different kind with sufficiently greater nucleation density than the material of the remaining surface is formed sufficiently finely so that only a single nucleus may grow, whereby a single crystal is grown selectively only at each site where such fine even different kind of material exists.

Since the selective growth of single crystal is determined depending on the electron state of the deposition surface, particularly the state of dangling bonds, the material with lower nucleation density ($SiO_2$) is not required to be a bulk material, but it may be formed on the surface of any desired material or substrate, etc. to form the above surface.

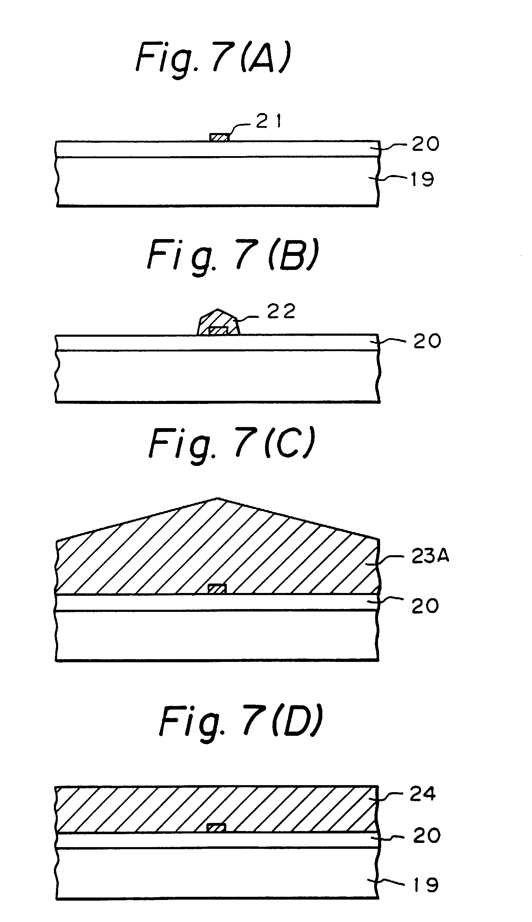

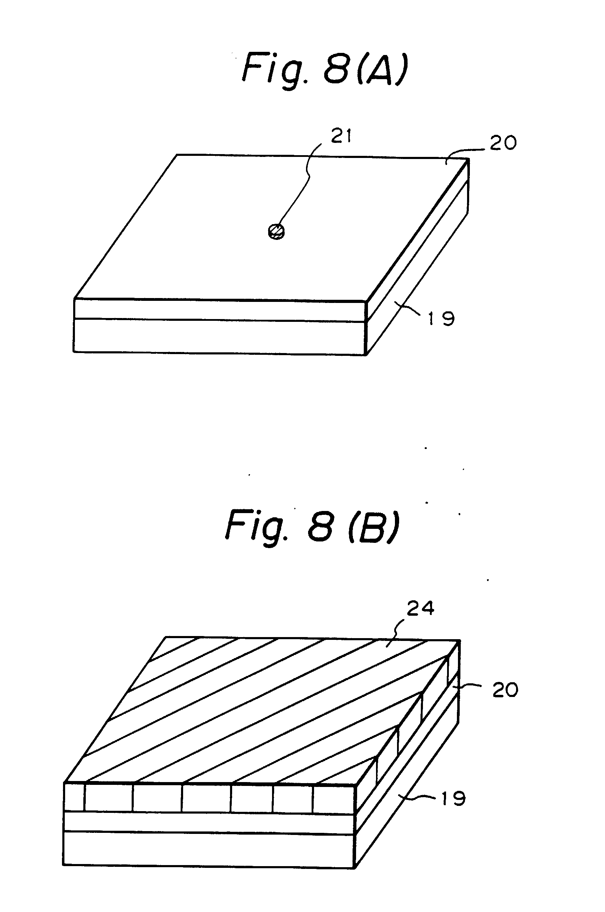

Figs. 7(A) - 7(D) illustrate diagrammatically the steps for illustration of the principle of production when forming practically a single crystal, and Figs. 8(A) and 8(B) are perspective views of Figs. 7(A) and 7(D).

First, as shown in Fig. 7(A) and Fig. 8(A), on the substrate 19, a thin film with small nucleation density enabling selective nucleation (nucleation surface ($S_{NDS}$)) is formed, and a material of different kind from the material forming the thin film 20 with small nucleation density is thinly deposited thereon, followed by patterning by lithography, etc. to form sufficiently finely a nucleation surface comprising a different kind of material ($S_{NDL}$).

However, the size, the crystal structure and the composition of the substrate 19 may be as desired, and it may be also a substrate having a functional element formed thereon. Also, the nucleation surfaces ($S_{NDL}$) 21 comprising a different kind material is inclusive of modified regions having excessively Si, N, etc. formed by ion implantation of Si, N, etc. on the thin film 21, as described above.

Next, by selecting appropriate deposition conditions, a single nucleus of a thin film material is formed only on the nucleation surface ($S_{NDL}$) 21. That is, the nucleation surface ($S_{NDL}$) 21 is required to be formed sufficiently small to the extent that only a single nucleus may be formed. The size of the nucleation surface ($S_{NDL}$), which depends on the kind of the material, may be several $\mu$m or less. Further, the nucleus grows while maintaining a single crystal structure to become a single crystal grain 22 shaped in an island as shown in Fig. 7(B). For the island shaped single crystal grain 22 to be formed, it is desirable to determine the conditions so that no nucleation may occur at all on the thin film 20.

The island-shaped single crystal grain 22 further grows while maintaining the single crystal structure with the nucleation surface ($S_{NDL}$) 21 at the centre (lateral overgrowth), whereby the thin film 20 can be covered therewith as shown in Fig. 7 (C) (single crystal 23A).

Subsequently, the single crystal 23A is flattened by or polishing to form a single crystal layer 24 on the thin film 20, on which a desired element can be formed, as shown in Fig. 7(D) or Fig. 8(B).

Thus, since in this case a non-nucleation surface ($S_{NDS}$) is formed on the substrate 19, any desired material can be used for the substrate 19 which is the supporting member. Further, in such case, even if the substrate 19 is one having a functional element, etc. formed by a conventional semiconductor technique, a single crystal 24 can be easily formed thereon.

In the above example, the non-nucleation surface ($S_{NDS}$) was formed with the thin film 21, but a substrate comprising a material with small nucleation density (ND) enabling selective nucleation may be used as such, and the single crystal layer may be formed similarly with provision of the nucleation surface ($S_{NDL}$) at any desired position.

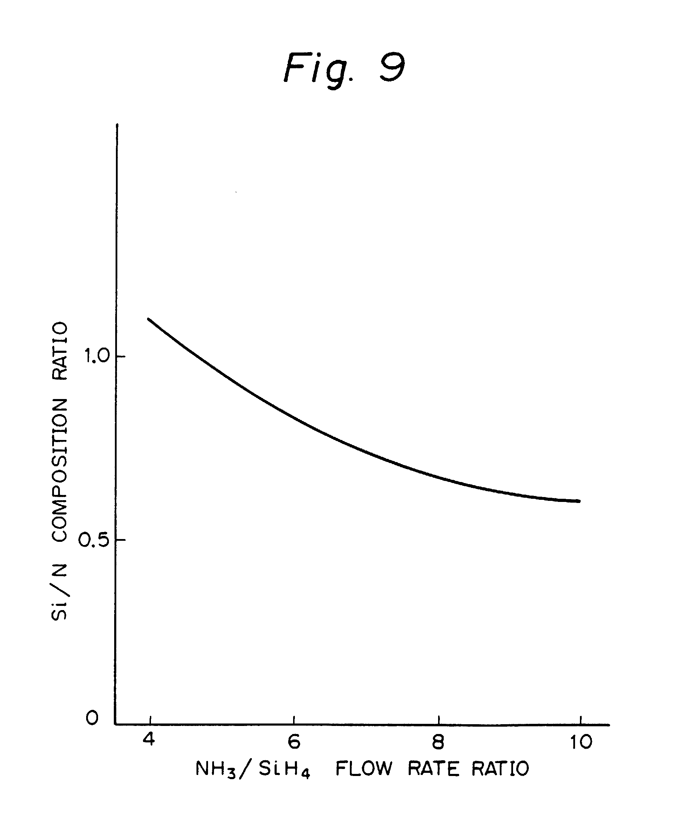

Fig. 9 is a graph showing one example of the relationship between the flow rate ratio of $NH_3$ to SiH4 and the composition ratio of Si/N in the silicon nitride film formed.

The deposition conditions at this time were RF output of 175 W, substrate temperature of 380 °C, and the $SiH_4$ gas flow rate was fixed at 300 cc/min., with the flow rate of $NH_3$ gas being varied. As shown in the same graph, by varying the gas flow rate ratio of $NH_3/SiH_4$ from 4 to 10, the Si/N ratio in the silicon nitride film was found to vary from 11 to 1.58, as clarified by the Auger's electron spectroscopy.

Also, the composition of the silicon nitride film formed according to the reduced pressure CVD method by introducing $SiH_2Cl_2$ gas and $NH_3$ gas under the conditions of a reduced pressure of 40 Pa (0.3 Torr) and a temperature of about 800 °C, was found to be approximate to $Si_3N_4$ (Si/N=0.75) which is substantially the stoichiometric ratio.

Also, the silicon nitride film formed by heat treatment at about 1200 °C in ammonia or $N_2$ (hot nitriding method) can obtain a composition further approximate to the stoichiometric ratio, because the formation method is practiced under thermal equilibrium.

By use of the silicon nitride formed according to various methods as described above as the material for forming the nucleation surface ($S_{NDL}$) with higher nucleation density of Si than $SiO_2$, the above nucleus of Si can be permitted to grow on the nucleation surface ($S_{NDL}$) comprising silicon nitride, whereby a Si single crystal is formed based on the nucleation density difference ($\Delta$ND) corresponding to the chemical composition ratio of silicon nitride.

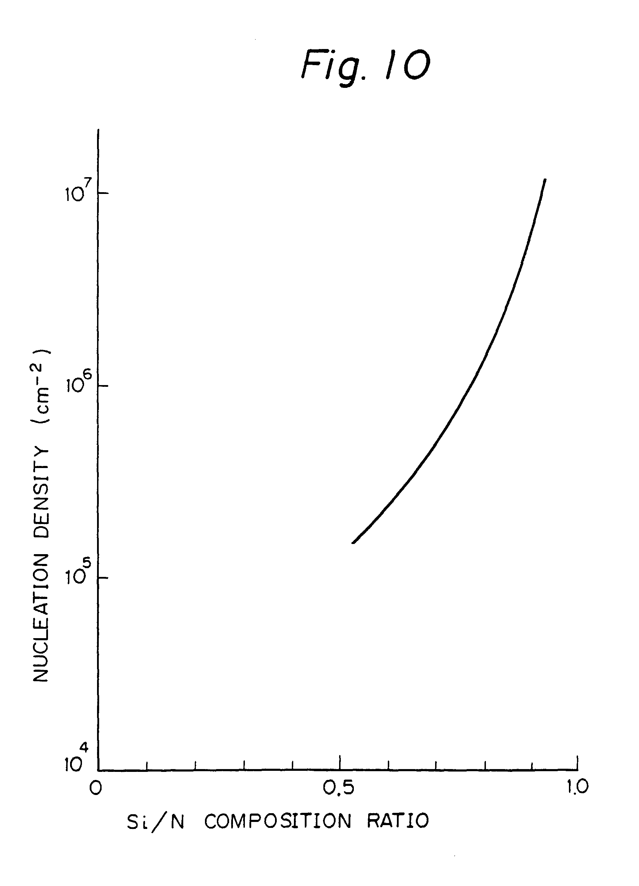

Fig. 10 is a graph showing the relationship between Si/N composition ratio and nucleation density (ND). As shown in Fig. 10, by varying the chemical composition ratio of the silicon nitride film, the nucleation density of the Si single crystalline nucleus formed thereon varies to great extent. The nucleation conditions in the graph in Fig. 10 correspond to the case when $SiCl_4$ gas is reduced to $2.33 \times 10^4$ Pa (175 Torr, and reacted with $H_2$ at 1000 °C to form Si single crystalline nuclei. Of course, another graph will be obtained if nucleation conditions such as gas species, pressure, temperature, etc. are varied.

Thus, the phenomenon of the nucleation density being varied depending on the chemical composition of silicon nitride has an influence on the size (area) of the nucleation surface ($S_{NDL}$), when silicon nitride is used as the material for forming the nucleation surface ($S_{NDL}$) which is to be formed sufficiently fine to the extent that a single crystal is permitted to grown. More specifically, when silicon nitride having a composition with large nucleation density (ND) is used, by forming the nucleation surface ($S_{NDL}$) extremely finely as compared with the case of silicon with relatively smaller nucleation density (ND) than that, only a single nucleus can be formed on the nucleation surface ($S_{NDL}$).

Such points are also applicable to other materials for forming the nucleation surface ($S_{NDL}$) as the same tendency.

Accordingly, in the present invention, that the nucleation density (ND) and the size of the nucleation surface ($S_{NDL}$) should be selected suitably as desired. For example, under the nucleation conditions for obtaining a nucleation density (ND) of ca. $10^5$ cm $^{-2}$, the size of the nucleation surface ($S_{NDL}$) may be about 4 $\mu$m or less, whereby only a single nucleus can be selectively formed.

In that case, the Si/N composition ratio is about 0.5.

As another method for realizing the nucleation density difference ($\Delta$ND) in the case of forming a Si single crystalline, a modified region with a desired size can be formed on the SiO2 layer surface by ion implantation of Si, N, P, B, F, Ar, He, C, As, Ga, Ge, etc. locally on the surface of a layer comprising $SiO_2$ which is the material for forming the non-nucleation surface ($S_{NDS}$) with small nucleation density to make the modified region the nucleation surface with larger nucleation density (ND) ($S_{NDL}$).

For example, the $SiO_2$ surface may be covered with a resist, and the desired sites are exposed, developed and dissolved to leave the $SiO_2$ surface exposed partially.

Subsequently, by use of $SiF_4$ gas as the source gas, Si ions are implanted at 10 keV at a density of 1 x $10^{16}$ to 1 x $10^{18}$ cm$^{-2}$.

The projection flight length in this case is 11.4 nm (114 Å), and the Si concentration reaches ca. $10^{22}$cm$^{-3}$ on the $SiO_2$ surface. Since $SiO_2$ layer is originally amorphous, the modified region implanted with Si ions to be made Si excessive is also amorphous.

For formation of a modified region, ion implantation can be effected with a resist as a mask. Alternatively, narrow beam Si ions may be implanted at desired positions of the $SiO_2$ surface without use of a resist mask using a converged ion beam technique.

After ion implantation is thus effected, the resist can be peeled off to form a modified region with excessive Si in the $SiO_2$ surface at each desired position with a desired size. On the $SiO_2$ deposition surface having such modified regions formed therein, Si single crystal is permitted to grow in gas phase.

Fig. 11 is a graph showing the relationship between Si ion implantation rate and nucleation density.

As shown in Fig. 11, it can be understood that nucleation density (ND) is increased as the amount of $Si^+$ implanted is larger.

Accordingly, by forming sufficiently finely the modified region, only a single nucleus of Si can be grown with the modified region as the nucleation surface ($S_{NDL}$), whereby a single crystal can be grown as described above.

Sufficiently fine formation of the modified region to the extent that a single nucleus can grow can be accomplished easily by patterning of a resist or narrowing of the beam of the converged ion beam.

For growth of a single crystal by selective nucleation of Si, the CVD method is not limitative, but it is also possible to use a method in which Si is evaporated by an electron gun in vacuum ($<10^{-4}$ Pa) (($< 10^{-6}$ Torr)) to be deposited on a heated substrate. Particularly, according to the MBE (Molecular Beam Epitaxy) method in which vapour deposition is effected in ultra-high vacuum ($<10^{-7}$ Pa) (($< 10^{-9}$ Torr)), it has been known in the art that the reaction begins between Si beam and $SiO_2$ at a substrate temperature of 900°C or higher, whereby nucleation of Si becomes zero on $SiO_2$ (T. Yonehara, S. Yoshioka and S. Miyazawa, Journal of Applied Physics 53, 10, p. 6839, 1983).

By utilising this phenomenon, a single nucleus can be formed on fine silicon nitride spots on $SiO_2$ with complete selectivity and single crystalline Si can be grown therefrom. The single crystal growth conditions may be, for example, vacuum degree of ($10^{-6}$Pa) ($10^{-8}$ Torr) or less, Si beam intensity of 9.7 x $10^{14}$ atoms/cm$^2$ sec, and substrate temperature of 900°C to 1000°C.

In this case, through the reaction $SiO_2$ + Si $\rightarrow$ 2SiO $\uparrow$, a reaction product with remarkably high vapour pressure of SiO is formed, whereby etching of $SiO_2$ itself with Si through such evaporation occurs.

In contrast, on silicon nitride, no such etching phenomenon occurs, but nucleation of Si single crystal, and growth of single crystal occurs.

Therefore, as the material with higher nucleation density (ND) for forming the nucleation surface ($S_{NDL}$), other than silicon nitride, tantalum oxide ($Ta_2O_5$), silicon nitride oxide (SiON), etc. can be used to obtain the same effect. Thus, by forming these materials with a small area to form the above nucleation surface ($S_{NDL}$), single crystals of Si can be grown similarly.

## Claims

1. A method for producing a plurality of silicon single crystal islets (6) in the surface of a recessed $SiO_2$ substrate (1), which method comprises:

   establishing a deposition surface area (2) in each one of a plurality of the recesses (4) of the substrate (1), each said deposition surface area (2) having a property of nucleating silicon at a higher nucleation density than that of the bottom surface of each recess (4), and each being limited in area to a size which is suitable for forming thereon a single nucleus of silicon from which a single crystal of silicon is to be grown; depositing silicon (1) and forming thereby, selectively on substantially each of the deposition surface areas (2), a single nucleus of silicon from which a single crystal of silicon is to be grown;
   growing single crystal silicon (5) from each single nucleus and filling thereby each respective recess (4); and
   subjecting the substrate (1,5) to rotary working whilst it is pressed against a polishing pad (9) provided on a rotary disc (8), whilst feeding from a polishing liquid source (10) a polishing liquid of ethylenediamine, pyrocatechol and water which reacts with silicon to form Si $(OH)_6{}^{2-}$ which is removed by the polishing pad (9) so that surplus single crystal silicon (5) is removed until polishing is automatically stopped by the $SiO_2$ surface which acts as a stopper.

2. A method as claimed in claim 1 wherein said deposition surface areas are established by depositing a film of $Si_3N_4$ on the surface of the recessed $SiO_2$ substrate by reduced pressure chemical deposition followed by plasma etching in the presence of a patterned photoresist mask.

## Patentansprüche

1. Verfahren zur Herstellung einer Vielzahl von Siliciumeinkristallinseln (6) in der Oberfläche eines ausgesparten $SiO_2$-Substrats (1), wobei das Verfahren umfaßt:

das Einrichten einer Abscheidungsoberfläche (2) in jeder der Vielzahl von Aussparungen (4) des Substrats (1), wobei jede Abscheidungsoberfläche (2) die Eigenschaft der Siliciumkeimbildung mit einer höheren Keimbildungsdichte als der der Bodenfläche einer jeden Aussparung (4) besitzt, und wobei jede in der Fläche auf eine Größe begrenzt ist, die zur Bildung eines einzelnen Siliciumkristallkerns darauf, von welchem ein Siliciumeinkristall zu züchten ist, geeignet ist;
das Abscheiden von Silicium (1) und dadurch das selektive Bilden eines einzelnen Siliciumkristallkerns, von welchem ein Siliciumeinkristall zu züchten ist, auf im wesentlichen jeder der Abscheidungsoberflächen (2);
das Züchten eines Siliciumeinkristalls (5) von jedem einzelnen Kristallkern und dadurch das Auffüllen jeder der jeweiligen Aussparungen (4); und
Unterziehen des Substrats (1,5) einer Rotationsbearbeitung, während der es gegen eine auf einer Drehscheibe (8) angebrachte Polierscheibe (9) gepreßt wird, während von einer Polierflüssigkeitsquelle (10) eine Polierflüssigkeit aus Ethylendiamid, Pyrocatechin und Wasser zugeführt wird, die mit Silicium unter Bildung von $Si(OH)_6{}^{2-}$ reagiert, was durch die Polierscheibe (9) entfernt wird, so daß überschüssiger Siliciumeinkristall (5) entfernt wird, bis das Polieren automatisch durch die als Stopper wirkende $SiO_2$-Oberfläche beendet wird.

2. Verfahren nach Anspruch 1, wobei die Abscheidungsoberflächen durch Abscheiden eines Films aus $Si_3N_4$ auf der Oberfläche des ausgesparten SiO2-Substrats durch chemische Abscheidung bei vermindertem Druck, gefolgt von Plasmaätzen in Gegenwart einer gemusterten Photoresistmaske eingerichtet werden.

## Revendications

1. Procédé de production d'une pluralité d'îlots de silicium monocristallin (6) dans la surface d'un substrat (1) de $SiO_2$ à évidements, ledit procédé comprenant les étapes consistant à :

créer une surface spécifique de dépôt (2) dans chaque évidement d'une pluralité d'évidements (4) du substrat (1), chacune desdites surfaces spécifiques de dépôt (2) ayant une propriété de nucléation du silicium à une densité de nucléation supérieure à celle de la surface inférieure de chaque évidement (4), et chacune ayant une aire limitée à une dimension qui est appropriée à la formation, sur celle-ci, d'un noyau unique de silicium à partir duquel doit s'effectuer le tirage d'un monocristal de silicium ;

déposer du silicium (1) et former ainsi, de façon sélective sensiblement sur chacune des surfaces spécifiques de dépôt (2), un noyau unique de silicium à partir duquel doit s'effectuer le tirage d'un monocristal de silicium ;

effectuer le tirage de silicium monocristallin (5) à partir de chaque noyau unique et remplir ainsi chaque évidement respectif (4) ; et

soumettre le substrat (1, 5) à un usinage par rotation tout en le comprimant contre un tampon de polissage (9) prévu sur un disque rotatif (8), tout en amenant, à partir d'une source (10) de liquide de polissage, un liquide de polissage d'éthylènediamine, de pyrocatéchol et d'eau qui réagit avec le silicium pour former du $Si(OH)_6^{2-}$ qui est éliminé par le tampon de polissage (9), de sorte que le silicium monocristallin (5) en surplus est éliminé jusqu'à ce que le polissage soit automatiquement stoppé par la surface de SiO2 qui agit comme une couche d'arrêt.

2. Procédé selon la revendication 1, dans lequel on crée lesdites surfaces spécifiques de dépôt en déposant un film de $Si_3N_4$ sur la surface du substrat de $SiO_2$ à évidements par dépôt chimique à une pression réduite, suivi d'une attaque par plasma en présence d'un masque de photo-résist à motifs.

## Fig. I (A)

## Fig. I (B)

## Fig. I (C)

## Fig. 2

## Fig. 3

# Fig. 4

# Fig. 5(A)

# Fig. 5(B)

# Fig. 6

## Fig. 7 (A)

21
20
19

## Fig. 7 (B)

22
20

## Fig. 7 (C)

23A
20

## Fig. 7 (D)

24
20
19

## Fig. 8(A)

## Fig. 8 (B)

# Fig. 9

# Fig. 10

# Fig. 11